# EUROPÄISCHE PATENTSCHRIFT

(11) **EP 2 711 183 B1**
(45) Veröffentlichungstag und Bekanntmachung des Hinweises auf die Patenterteilung: **22.04.2015**
(21) Anmeldenummer: 13185382.2
(22) Anmeldetag: 20.09.2013
(51) Int. Cl.: B41F 15/08, B41F 15/26, H05K 3/12, B41F 15/18, H05K 3/00

(54) **Druckvorrichtung, Drucksystem, Verfahren**
Printing apparatus, printing system, method
Dispositif d'impression, système d'impression, procédé

(30) Priorität: 25.09.2012 DE 102012019573
(43) Veröffentlichungstag der Anmeldung: 26.03.2014
(73) Patentinhaber: Ekra Automatisierungssysteme GmbH, 74357 Bönnigheim (DE)
(72) Erfinder: Brosi, Ralf, 71723 Großbottwar (DE); Plachy, Franz, 74336 Brackenheim (DE); Szekeresch, Jacob, 75328 Schömberg (DE); Vegelahn, Torsten, 75447 Sternenefels (DE)
(74) Vertreter: Clarenbach, Carl-Philipp

(56) Entgegenhaltungen:
- EP-A2- 2 050 567
- DE-A1-102008 024 981
- US-A1- 2011 297 020
- US-A1- 2012 216 690

## Beschreibung

Die Erfindung betrifft eine Druckvorrichtung zum gleichzeitigen Bedrucken mehrerer Substrate, mit einer insbesondere austauschbaren Tragplatte, auf der die Substrate nebeneinander angeordnet/anordenbar sind, mit einer wenigstens eine Druckmaske aufweisenden Druckeinrichtung und mit einer Justiervorrichtung zum Ausrichten der Substrate bezüglich der wenigstens einen Druckmaske vor einem Druckvorgang, wobei die Justiereinrichtung eine Erfassungseinrichtung zum Erfassen der Lage der Substrate bezüglich der Druckmaske aufweist, sowie eine Greifeinrichtung, die dazu ausgebildet ist, jeweils ein Substrat zu greifen, von der Tragplatte zu entfernen und nach erfolgter Ausrichtung wieder auf die Tragplatte abzusetzen.

Ferner betrifft die Erfindung ein Drucksystem mit einer Druckvorrichtung zum gleichzeitigen Bedrucken mehrerer Substrate und mit mehreren Tragplatten, auf denen jeweils mehrere Substrate nebeneinander angeordnet/anordenbar sind.

Weiterhin betrifft die Erfindung ein Verfahren zum Betreiben einer derartigen Druckvorrichtung oder eines derartigen Drucksystems.

Druckvorrichtungen, Drucksysteme oder entsprechende Betriebsverfahren sind aus dem Stand der Technik bekannt. Moderne Druckvorrichtungen sind derart ausgebildet, dass sie selbsttätig das zu bedruckende Gut bezüglich einer Druckmaske einer Druckeinrichtung ausrichten, um einen automatisierten Druckvorgang optimal gestalten zu können. Ist nur ein einzelnes Druckgut beziehungsweise ein einzelnes Substrat zu bedrucken, so gestaltet sich die Ausrichtung des Substrats bezüglich der Druckmaske verhältnismäßig einfach. Um jedoch einen hohen Durchsatz bei modernen Druckvorrichtungen zu erreichen, werden häufig gleichzeitig mehrere Substrate bedruckt. Hier gestaltet sich die Ausrichtung der einzelnen Substrate bezüglich der Druckmaske schwieriger. In der Regel werden dabei der Druckvorrichtung die Substrate mittels einer Tragplatte zugeführt, auf welcher die Substrate nebeneinander angeordnet sind. Unter einer Anordnung der Substrate nebeneinander ist eine Anordnung mehrere Substrate zu verstehen, die in einer Draufsicht gesehen in mindestens eine Richtung eine Reihe bildend benachbart zueinander angeordnet sind. Die Substrate können somit beispielsweise in Reihenform oder Matrixform auf der Tragplatte angeordnet sein. Natürlich ist mit Bezug auf die Tragplatte auch eine schräg verlaufende Verteilung der Substrate über die Tragplatte hinweg denkbar. Es kommt darauf an, dass die Substrate nebeneinander, also benachbart zueinander, und nicht übereinander angeordnet sind/werden. Von einer bestimmten Seitenansicht aus betrachtet, können die Substrate beispielsweise sowohl nebeneinander als auch hintereinander angeordnet sein, um eine matritzenförmige Anordnung zu erreichen. Eine Justiervorrichtung nimmt dann die Ausrichtung der einzelnen Substrate bezüglich der Druckmaske vor. Dazu wird zunächst die Position und Ausrichtung der einzelnen Substrate mittels einer Erfassungseinrichtung insbesondere optisch erfasst. Dabei fährt ein Kamerasystem jede Position der Substrate einzeln an, um die Lage des jeweiligen Substrats bezüglich der Druckmaske zu erfassen, während parallel eine zusätzliche Greifeinrichtung verwendet wird, die jedes Substrat nach erfolgter Erfassung seiner Lage von der Tragplatte entfernt, zur Druckmaske ausrichtet und anschließend wieder zurück auf die Tragplatte legt. Um alle zur Ausrichtung notwendigen Bewegungen auszuführen, ist die Greifeinrichtung komplex ausgebildet und verbraucht auch entsprechend viel Bauraum. Da sich die Greifeinrichtung dabei zumindest zeitweise zwischen der Druckmaske und der Tragplatte befindet, bedeutet dies automatisch eine entsprechend große Auslegung des Zwischenraums zwischen Druckmaske und Tragplatte, die die Gesamtgröße der Druckvorrichtung beeinträchtigt.

Dokument US-A- 2011/0297020 offenbart eine Druckvorrichtung gemäß Oberbegriff von Anspruch 1.

Der Erfindung liegt somit die Aufgabe zugrunde, eine Druckvorrichtung, ein Drucksystem sowie ein entsprechendes Betriebsverfahren zu schaffen, die eine vereinfachte Ausrichtung der Substrate bei bleibender Druckgenauigkeit und Wiederholbarkeit und in Bauraum sparender Ausführung ermöglicht.

Die der Erfindung zugrunde liegende Aufgabe wird durch eine Druckvorrichtung mit den Merkmalen des Anspruchs 1 gelöst. Sie hat den Vorteil, dass die Greifeinrichtung vereinfacht und kleiner ausgebildet werden kann, wobei gleichzeitig die volle Funktionsfähigkeit der Druckvorrichtung auch bei einer hohen Arbeitsgeschwindigkeit und Genauigkeit gewährleistet wird. Erfindungsgemäß ist hierzu vorgesehen, dass die Justiereinrichtung der Druckvorrichtung eine der Tragplatte zugeordnete Ausrichteinrichtung aufweist, die die Tragplatte in einer Ebene verschiebt und/oder verdreht, um das durch die Greifeinrichtung von der Tragplatte jeweils entfernte Substrat auszurichten. Erfindungsgemäß ist es also nicht die Greifeinrichtung, sondern die Ausrichteinrichtung, die zum Ausrichten der Substrate dient. Die Ausrichteinrichtung ist dabei direkt oder indirekt mit der Tragplatte verbunden, um diese insbesondere in ihrer Ebene zu verschieben und/oder zu verdrehen, während die Greifeinrichtung das jeweils auszurichtende Substrat von der Tragplatte entfernt hält.

Zweckmäßigerweise sind die Justiereinrichtung und/oder eine die Druckvorrichtung ansteuernde Steuereinheit derart ausgebildet, dass die Tragplatte derart verschoben und/oder verdreht wird, dass, wenn das zuvor entfernte Substrat wieder auf die Tragplatte, die sich in der verschobenen und/oder verdrehten Lage befindet, abgesetzt wird, durch die nachfolgende Zurückverlagerung der Tragplatte in ihrer Ausgangslage die Ausrichtung des Substrats in die gewünschte Lage bezüglich der Druckmaske erfolgt. Die Greifeinrichtung muss somit lediglich das Substrat von der Tragplatte lösen und entfernen, so dass die Tragplatte unabhängig von dem Substrat verschoben/verdreht werden kann. Hierdurch vereinfachen sich die Ausbildung der Greifeinrichtung und damit der Gesamtaufbau der Druckvorrichtung deutlich.

Gemäß einer vorteilhaften Weiterbildung der Erfindung ist vorgesehen, dass die Erfassungseinrichtung vor der Ausrichtung der Substrate die Lage der Tragplatte erfasst, und dass die Ausrichteinrichtung nach dem Ausrichten der Substrate die Tragplatte in die ursprüngliche Ausgangslage vor der Ausrichtung der Substrate zurückverlagert. Theoretisch ließe sich die Tragplatte auch ohne eine vorherige Erfassung ihrer Position/Ausrichtung in ihre ursprüngliche Position/Ausrichtung zurückverlagern, da ihre Positionsveränderung durch den Ausrichtvorgang bedingt der entsprechenden Ansteuerung bekannt ist, und insofern auch rückgängig gemacht werden kann. Zum Erhöhen der Präzision ist es jedoch vorteilhaft, wenn die (Ausgangs-)Lage der Tragplatte vor einem ersten Ausrichtvorgang zusätzlich erfasst wird.

Besonders bevorzugt ist die Justiereinrichtung der Druckvorrichtung derart ausgebildet, dass nach jeder erfolgten Ausrichtung eines Substrats bezüglich der Druckmaske die Tragplatte wieder zurück in ihre Ausgangsposition verfahren wird. Alternativ ist es auch denkbar, die Tragplatte erst nachdem das letzte Substrat ausgerichtet wurde, zurück in die Ausgangsposition zu verlagern. Dies bedeutet jedoch einen erhöhten Rechenaufwand und ist je nachdem, wie groß die Verstellwege zum Ausrichten einzelner Substrate sind, mit zunehmender Anzahl der Substrate schwieriger durchzuführen. Vorteilhafterweise wird die Lage der Tragplatte und/oder der Substrate mittels Orientierungsmarkierungen auf den Substraten und/oder auf der Tragplatte durchgeführt, die mittels der Erfassungseinrichtung optisch erfasst werden. Die Erfassungseinrichtung ist hierzu bevorzugt als Kameraeinheit ausgebildet.

Gemäß einer vorteilhaften Weiterbildung der Erfindung ist vorgesehen, dass die Druckvorrichtung eine Tragplattenaufnahme aufweist, der wenigstens ein ansteuerbarer Aktor der Ausrichteinrichtung, insbesondere ein elektromotorisch, hydraulisch oder pneumatisch arbeitender Aktor, zum Verschieben und/oder Verdrehen der Tragplatte zugeordnet ist, und auf welcher die Tragplatte arretierbar, insbesondere automatisch arretierbar ist. Durch die Zuordnung des Aktors beziehungsweise der Ausrichteinrichtung zu der Tragplattenaufnahme ist eine indirekte Verbindung zwischen Ausrichteinrichtung und Tragplatte gegeben. Dies erlaubt eine einfache Ausrichteinrichtung, insbesondere dann, wenn es sich bei der Tragplatte um eine austauschbare Tragplatte handelt. Die Tragplattenaufnahme ist zweckmäßigerweise derart ausgebildet, dass sie zumindest im Wesentlichen an die Form der Tragplatte angepasst ist, um eine einfache Aufnahme und Ausrichtung der Tragplatte auf der Tragplattenaufnahme zu ermöglichen. Hierzu können beispielsweise Führungsschienen auf der Tragplattenaufnahme vorgesehen sein, die mit der Tragplatte zusammenwirken. Zweckmäßigerweise sind Arretiermittel vorgesehen, die die Arretierung auf der Tragplatte, insbesondere automatisch gewährleisten, so dass die Tragplatte bezüglich der Tragplattenaufnahme insbesondere während des Ausrichtvorgangs unverrückbar angeordnet ist.

Vorzugsweise sind die Greifeinrichtungen und die Erfassungseinrichtung als eine Einheit ausgebildet, die in einer Ebene insbesondere parallel zur Druckmaske verfahrbar ist. Durch die Verknüpfung der Greifeinrichtung und der Erfassungseinrichtung zu einer gemeinsamen Einheit, wird die Druckvorrichtung insgesamt weiter vereinfacht, da keine extra Stellmittel zum Verfahren der Erfassungseinrichtung notwendig sind. Hierdurch werden Kosten und Bauraum gespart. Die insbesondere parallele Verfahrbarkeit der Einheit verhindert Fehler bei der Erfassung und Ausrichtung der Substrate.

Gemäß einer vorteilhaften Weiterbildung der Erfindung ist vorgesehen, dass die Greifeinrichtung als Saug-Greifeinrichtung ausgebildet ist. Die Saug-Greifeinrichtung zeichnet sich dadurch aus, dass sie die Substrate bevorzugt lediglich von oben kontaktiert und sie per Saugwirkung von der Tragplatte entfernt. Hierdurch wird eine besonders einfache Ausführungsform der Greifeinrichtung geboten, die im Zusammenspiel mit der der Tragplatte zugeordneten Ausrichteinrichtung zu einer Kosten- und Bauraum sparenden Ausführungsform der Druckvorrichtung führt. Gemäß einer alternativen Ausführungsform der Erfindung ist vorgesehen, dass die Greifeinrichtung als mechanische Greifeinrichtung ausgebildet ist, die sich dadurch auszeichnet, dass sie das jeweilige Substrat form- und/oder kraftschlüssig greift, um es von der Tragplatte zu entfernen. Hierzu kann die mechanische Greifeinrichtung beispielsweise einen oder mehrere mechanische Greifer aufweisen, die insbesondere mit einem oder mehreren Greiffingern versehen sind. Die Greifarme, insbesondere die Greiffinger sind dabei derart ausgebildet, dass sie zwischen Substrat und Tragplatte und/oder in einer entsprechenden Aussparung des Substrats seitlich einfahrbar sind, um dadurch ein formschlüssiges Greifen des jeweiligen Substrats zu ermöglichen.

Bevorzugt ist die Greifeinrichtung derart ausgebildet, dass sie eine Hubbewegung zum Entfernen des jeweiligen Substrats von der Tragplatte durchführt. Dazu ist die Greifeinrichtung vorzugsweise zumindest teilweise in ihrer Höhe verstellbar. Gemäß einer alternativ bevorzugten Ausführungsform ist vorgesehen, dass die Hubbewegung nicht durch die Greifeinrichtung, sondern durch den Drucktisch durchgeführt wird, indem dieser in seiner Höhe mittels eines entsprechenden Aktors verändert wird. In diesem Fall greift die Greifeinrichtung lediglich das Substrat, um es zu arretieren, während der Drucktisch von der Greifeinrichtung weg beziehungsweise nach unten gefahren wird, so dass sich das Substrat von dem Drucktisch und der darauf befindlichen Tragplatte entfernt. Natürlich ist auch eine Kombination dieser beiden Möglichkeiten/Verfahren denkbar, bei welcher sowohl die Greifeinrichtung als auch der Drucktisch eine Hubbewegung durchführt, um das jeweilige Substrat von der Tragplatte zu entfernen und wieder darauf abzusetzen.

Vorzugsweise weist die Tragplatte mehrere Durchbrüche auf, wobei der Tragplattenaufnahme mindestens eine Saugeinrichtung auf der den Substraten gegenüberliegenden Unterseite der Tragplatte aufweist, die den Durchbrüchen zugeordnet/zuordenbar ist, und die mittels Saugwirkung die Substrate auf der Tragplatte fixiert. Diese Art der Substratfixierung ist einfach und kostengünstig durchführbar und verhindert darüber hinaus eine mechanische Beanspruchung der Substrate, wie sie bei einer mechanischen Fixierung auftreten könnte. Insbesondere in Zusammenwirkung mit der Saug-Greifeinrichtung werden die Substrate dadurch besonders sanft durch die Druckvorrichtung behandelt, so dass eine Beschädigung der Substrate insgesamt vermieden wird. Dabei kann eine einzige Saugeinrichtung vorgesehen sein, die die gesamte Tragplatte von der Unterseite mit einem Vakuum beaufschlagt, oder es können mehrere Saugeinrichtungen vorgesehen sein, die bevorzugt derart über die Tragplattenaufnahme verteilt angeordnet sind, dass jeweils an der Stelle auf der Tragplatte, wo erwartungsgemäß ein Substrat angeordnet wird oder anordenbar ist, eine Sogwirkung beziehungsweise Saugwirkung einstellbar ist. Wird jedem Substrat beziehungsweise jedem möglichen Substrat eine eigene Saugeinrichtung zugeordnet, so sind diese Saugeinrichtungen bevorzugt derart einzeln ansteuerbar ausgebildet, dass das jeweils auszurichtende Substrat, das von der Greifeinrichtung von der Tragplatte entfernt werden soll, durch Abschalten/Deaktivieren der entsprechenden Saugeinrichtung leichter von der Tragplatte gelöst werden kann.

Vorzugsweise weist die Druckvorrichtung wenigstens eine Zuführeinrichtung zum Zuführen der Tragplatte zu der Tragplattenaufnahme sowie eine Ausführeinrichtung zum Entfernen der Tragplatte von der Tragplattenaufnahme auf. Insbesondere bei einer Ausbildung als austauschbare Tragplatte wird somit eine automatisierte Zuführung und Ausführung der Tragplatte in die Druckvorrichtung hinein und aus der Druckvorrichtung heraus geboten. Insbesondere bei einem Drucksystem, wie es im Folgenden beschrieben wird, erlauben Zuführeinrichtung und Ausführeinrichtung das nacheinander automatisierte Zuführen und Ausführen von mehreren Tragplatten, auf welchen entsprechende Substrate angeordnet/anordenbar sind. Gemäß einer alternativen Ausführungsform der Erfindung ist vorgesehen, dass die Druckvorrichtung eine Zu- und Abführeinheit aufweist, die die Tragplatte zur gleichen Seite der Druckvorrichtung in die Druckvorrichtung einführt und aus dieser wieder herausführt. Im Unterschied zu der getrennten Zuführung und Ausführung mittels der Ausführeinrichtung und der Zuführeinrichtung, die vorzugsweise an unterschiedlichen Seiten der Druckvorrichtung vorgesehen sind, wird hierdurch eine kompaktere Druckvorrichtung bereitgestellt.

Die erfindungsgemäße Aufgabe wird weiterhin durch ein Drucksystem mit den Merkmalen des Anspruchs 8 gelöst. Dieses Drucksystem weist erfindungsgemäß eine Druckvorrichtung auf, wie sie oben stehend beschrieben wurde. Darüber hinaus weist das Drucksystem mehrere Tragplatten auf, die der Druckvorrichtung zugeführt werden können, und auf welchen die jeweils mehreren Substrate nebeneinander angeordnet/anordenbar sind.

Vorzusgweise sind die Tragplatten und/oder die Substrate mit Orientierungsmarken versehen, die zum Bestimmen der Lage der Substrate und/oder der jeweiligen Tragplatte bezüglich der Druckmaske erfasst werden. Wie zuvor beschrieben, ist die Erfassungseinheit zweckmäßigerweise als Kameraeinheit ausgebildet, die die Orientierungsmarkierungen (Fiducials) erfasst. Durch die optische Erfassung der Lage der Substrate und/oder der Tragplatte wird eine genaue und kostengünstige Lagekorrektur der Substrate gewährleistet.

Schließlich wird die Erfindung durch ein Verfahren mit den Merkmalen des Anspruchs 10 gelöst, das zum Betreiben einer Druckvorrichtung oder eines Drucksystems, wie sie oben stehend beschrieben wurden, dient. Das Verfahren zeichnet sich erfindungsgemäß dadurch aus, dass zunächst die Lage der Tragplatte erfasst wird. Dies kann dadurch erfolgen, dass die aktuelle Lage der Tragplattenaufnahme, die der Steuereinheit bekannt ist, ausgelesen und/oder gespeichert oder einfach als Ausgangslage beziehungsweise Nullpunkt definiert wird. Alternativ kann die Lage mittels der Erfassungseinrichtung bestimmt werden. Anschließend wird nacheinander die Lage jeweils eines Substrats bezüglich der Druckmaske der Druckeinrichtung mittels der Erfassungseinrichtung erfasst. Nachdem die Lage aller Substrate oder jeweils eines Substrats erfasst wurde, werden die Substrate nacheinander oder das jeweils eine Substrat mit der Greifeinrichtung angehoben beziehungsweise von der Tragplatte entfernt, dann wird die Tragplatte verschoben oder verdreht, um das Substrat bezüglich der Druckmaske derart auszurichten, dass das jeweilige auf die verschobene oder verdrehte Tragplatte anschließend wieder abgesetzte Substrat durch ein Zurückverlagern der Tragplatte in die im ersten Schritt erfasste/bestimmte Lage der Tragplatte bezüglich der Druckmaske ausgerichtet beziehungsweise in seiner Lage korrigiert wird. Nach dem Verdrehen/Verschieben der Tragplatte in der Ebene wird das jeweilige Substrat also wieder zurück auf die Tragplatte abgesetzt, anschließend wird die Tragplatte wieder in die im ersten Schritt erfasste Ausgangslage zurückverlagert, insbesondere nach jeder erfolgten Ausrichtung eines Substrats und spätestens nachdem alle Substrate ausgerichtet wurden, und ein Druckvorgang durchgeführt. Das Verfahren führt zu den oben bereits genannten Vorteilen. Bevorzugte Ausführungsformen des Verfahrens ergeben sich durch die oben bereits beschriebenen Merkmale.

Im Folgenden soll die Erfindung anhand der Zeichnung näher erläutert werden. Dazu zeigen:
- Figur 1: eine Druckvorrichtung in einer schematischen Darstellung,
- Figur 2: eine Tragplatte einer Druckvorrichtung in einer Draufsicht und
- Figur 3: ein weiteres Ausführungsbeispiel der Druckvorrichtung in einer schematischen Darstellung.

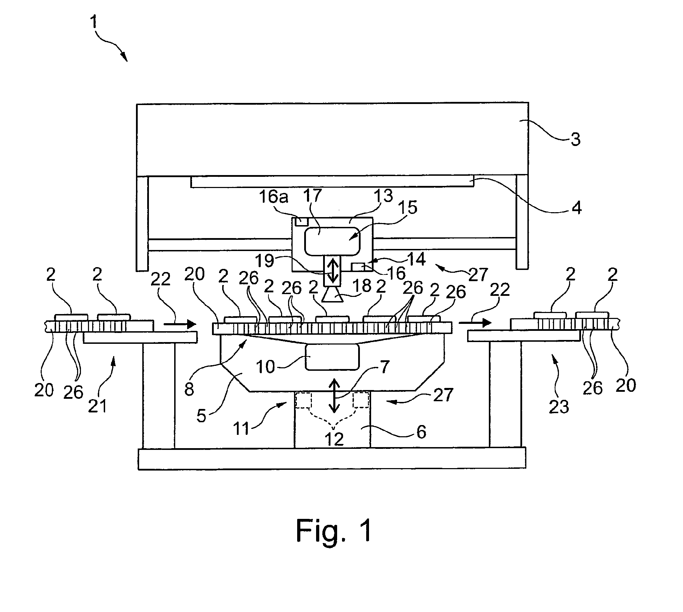

Figur 1 zeigt ein Ausführungsbeispiel einer vorteilhaften Druckvorrichtung 1 in einer vereinfachten beziehungsweise schematischen Seitenansicht. Die Druckvorrichtung 1 dient zum gleichzeitigen Bedrucken von Substraten 2, insbesondere Leiterplatten, Keramiksubstraten, Solarzellen, Folien, Glasteile, elektronische Bausteine (Chips), insbesondere Ball-Grid-Arrays (BGAs), oder Dergleichen, die vor einem Druckvorgang automatisch in eine für den Druck optimale Lage ausgerichtet werden.

Die Druckvorrichtung 1 weist hierzu eine Druckeinrichtung 3 mit einer Druckmaske 4 auf. Mittels eines hier nicht dargestellten Rakels der Druckeinrichtung 3 kann ein Druckmedium durch die Druckmaske 4 auf die Substrate 2 aufgebracht werden.

Weiterhin weist die Druckvorrichtung 1 einen Drucktisch 5 auf, auf welchem die Substrate vor dem Druckvorgang angeordnet werden. Der Drucktisch 5 weist einen Sockel 6 auf, auf welchem der Drucktisch 5 höhenverstellbar angeordnet ist. Hierzu ist zweckmäßigerweise ein elektromotorischer, pneumatischer oder hydraulischer Aktor im Drucktisch 5 vorgesehen, um den Drucktisch 5 in Richtung des Doppelpfeils 7 zu verlagern. Der Drucktisch 5 weist an seiner der Druckeinrichtung 3 zugewandten Oberseite eine Tragplattenaufnahme 8 auf, auf deren Funktion später näher eingegangen werden soll. Der Tragplattenaufnahme 8 ist eine Saugeinrichtung 10 zugeordnet, die in dem Drucktisch 5 angeordnet ist, um in Richtung der Tragplattenaufnahme 8 bei Bedarf einen Unterdruck erzeugen zu können.

Weiterhin weist der Drucktisch 5 eine Ausrichteinrichtung 11 auf, die mehrere Aktoren 12 umfasst, welche mit der Tragplattenaufnahme 8 zusammenwirken, um diese in einer Ebene zu verschieben und/oder zu verdrehen. Die Aktoren 12 sind vorzugsweise pneumatisch, hydraulisch oder elektromotorisch arbeitend ausgebildet. Durch Ansteuern der Aktoren 12 beziehungsweise der Ausrichteinrichtung 11 kann somit die Tragplattenaufnahme 8 bezüglich der Druckeinrichtung 3 verdreht beziehungsweise verschoben werden.

Weiterhin weist die Druckvorrichtung 1 eine Einheit 13 auf, die in einer Ebene parallel zur Druckmaske 4 und Tragplattenaufnahme 8 derart verfahrbar ist, dass sie in den Bereich zwischen Druckmaske 4 und Tragplattenaufnahme 8 hinein und aus diesem Bereich herausfahren und zumindest jeden Punkt in diesem Bereich erreichen kann. Die Einheit 13 umfasst eine Erfassungseinrichtung 14 sowie eine Greifeinrichtung 15, die zusammen in die Einheit 13 integriert und damit gemeinsam verfahrbar sind.

Die Erfassungseinrichtung 14 weist wenigstens eine Kamera 16 zum Erfassen der Lage der Substrate 2 auf. Die Kamera 16 kann sowohl monochrom als auch mit Farbdetektor arbeiten und als Flächen- oder Zeilenkamera ausgebildet sein. Um die Genauigkeit und die Geschwindigkeit der Positionserfassung zu erhöhen, ist es auch denkbar, mehrere Kameras 16 zu verwenden. Gemäß dem vorliegenden Ausführungsbeispiel weist die Erfassungseinrichtung 14 außerdem eine Kamera 16a auf, die zum Erfassen der Position/Ausrichtung der Druckmaske 4 vorgesehen ist. Die Druckmaske 4 ist hierzu vorzugsweise mit Orientierungsmarkierungen ("Fiducials") versehen, die von der Kamera 16a erfasst werden, wodurch die Positionsbestimmung beziehungsweise das Ausrichten der Substrate auf der Tragplatte in ihrer Genauigkeit weiter erhöht wird.

Die Greifeinrichtung 15 ist als Saug-Greifeinrichtung ausgebildet und weist hierzu eine eigene Saugvorrichtung 17 auf, die mit einem Sauggreifer 18 versehen ist, der gemäß Doppelpfeil 19 höhenverstellbar ausgebildet ist.

Die Druckvorrichtung 1 weist weiterhin eine austauschbare Tragplatte 20 auf, die auf der Tragplattenaufnahme 8 des Drucktisches 5 aufliegt und auf welcher die zu bedruckenden Substrate 2 nebeneinander, beispielsweise reihenförmig oder matrixförmig angeordnet/anordenbar sind. Die Tragplattenaufnahme 8 wird vorzugsweise derart ausgebildet, dass sie die Tragplatte 20 zumindest bereichsweise seitlich führt und somit eine Grundausrichtung der Tragplatte 20 auf dem Drucktisch 5 gewährleistet. Die Tragplattenaufnahme 8 weist dazu bevorzugt in Richtung der Pfeile 22 verlaufende Schienen beziehungsweise Führungen auf, die die Tragplatte 20 beidseitig führen. Vorteilhafterweise weist die Tragplattenaufnahme 8 außerdem Arretiermittel auf, die zum Fixieren der Tragplatte 20 auf dem Drucktisch 5 dienen. Die Arretiermittel erlauben zweckmäßigerweise eine automatische Fixierung der Tragplatte 20, und können pneumatisch, hydraulisch und/oder elektromotorisch betrieben werden.

Die Tragplatte 20 selbst ist mit einer Vielzahl von Durchbrüchen 26 versehen, die als Durchgangsbohrungen ausgebildet sind. Durch die Anordnung der Tragplatte 20 auf der Tragplattenaufnahme 8 sind die Durchbrüche 26 strömungstechnisch mit der Saugeinrichtung 10 des Drucktisches 5 verbunden.

Die Tragplatte 20 wird dem Drucktisch 5 durch eine Zuführeinrichtung 21 zugeführt und mittels einer Ausführeinrichtung 22 nach erfolgtem Druckvorgang von dem Drucktisch 5 wieder entfernt und aus der Druckvorrichtung 1 herausgeführt, wie durch Pfeile 22 angedeutet. Die Zuführeinrichtung 21 und die Ausführeinrichtung 22 können beispielsweise als Förderbänder oder dergleichen ausgebildet sein.

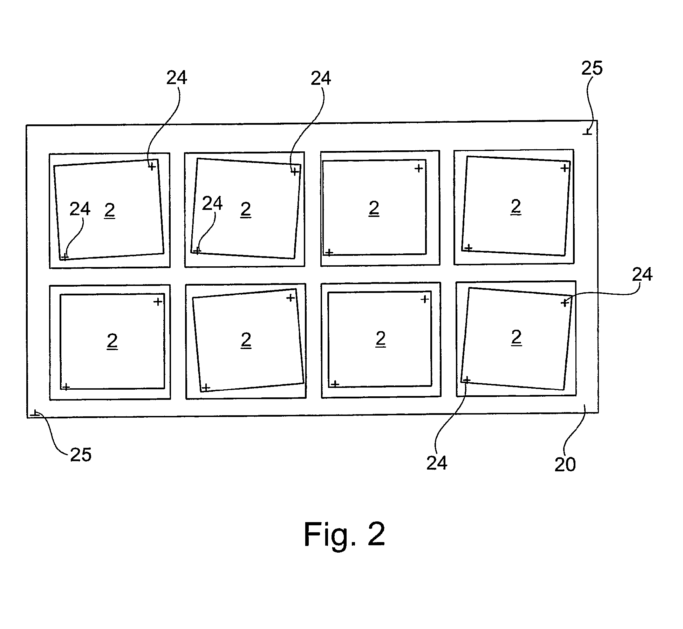

Figur 2 zeigt eine Draufsicht auf eine mit Substraten 2 bestückte Tragplatte 20, wobei die Durchbrüche 26 gemäß diesem Ausführungsbeispiel nur im Bereich der zu bedruckenden Substrate 2 angeordnet sind, so dass sie vorliegend von den Substraten 2 verdeckt werden. Die Substrate 2 sind dabei in zwei Reihen nebeneinander angeordnet. Sowohl die Substrate 2 als auch die Tragplatte 20 weisen jeweils Orientierungsmarkierungen (Fiducials) 24 beziehungsweise 25 auf, von denen aus Übersichtsgründen hier nur einige mit Bezugszeichen versehen sind. Mittels der Kamera 16 der Erfassungseinheit 14 sind die Orientierungsmarkierungen 24, 25 erfassbar und dadurch die jeweilige Lage der Tragplatte 20 und der Substrate 2 bestimmbar. Wie in Figur 2 beispielhaft angedeutet, sind die Substrate 2 zum Teil unterschiedlich ausgerichtet beziehungsweise positioniert. Diese unterschiedliche Ausrichtung/Positionierung beziehungsweise Lage der Substrate 2 kann beispielsweise durch eine automatisierte Bestückung der Tragplatte 20 mit den Substraten 2 bedingt sein.

Im Folgenden wird anhand der Figuren 1 und 2 erläutert, wie die Druckvorrichtung 1 funktioniert und betrieben wird. Zunächst wird die Tragplatte 20 von der Zuführeinrichtung 21 gemäß Pfeil 22 dem Drucktisch 5 derart zugeführt, dass sie auf der Tragplattenaufnahme 8 vorausgerichtet zum Liegen kommt. Mittels der nicht dargestellten Arretiermittel wird die Tragplatte 20 auf dem Drucktisch 5 beziehungsweise auf der Tragplattenaufnahme 8 fixiert. Anschließend wird mittels der Erfassungseinheit 14 die Lage der Tragplatte 20 anhand ihrer Orientierungsmarkierungen 25 erfasst. Zeitlich davor oder danach oder auch gleichzeitig werden die Orientierungsmarkierungen der Druckmaske 4 mittels der Kamera 16a erfasst, um die Position/Ausrichtung der Tragplatte 20 bezüglich der Druckmaske 4 zu bestimmen. Ist die Position der Druckmaske 4 prinzipiell bekannt, kann dieser Schritt und/oder die Kamera 16a gegebenenfalls auch entfallen. Durch Aktivierung der Saugeinrichtung 10 werden die Substrate 2 auf der Tragplatte 20 fixiert. Die Einheit 13 wird dann nacheinander über die Substrate 2 bewegt, um anhand der Orientierungsmarkierungen 24 die Lage des jeweiligen Substrates 2 zu erfassen. Die Lage der Substrate 2 wird dann mit der Lage der Druckmaske 4 verglichen. Hierzu können beispielsweise auch an der Druckmaske 4 entsprechende Orientierungsmarkierungen vorgesehen sein, die von der Einheit 13 beziehungsweise der Erfassungseinheit 14 erfasst werden. Da der die Druckvorrichtung 1 ansteuernden Steuereinheit die Gestaltung der Druckmaske 4 bekannt ist, kann sie anhand der nunmehr erfassten Daten bezüglich der Lage der Substrate 2 bezüglich der Druckmaske 4 eine Abweichung des jeweiligen Substrats 2 von einer optimalen Ausrichtung beziehungsweise Lage bezüglich der Druckmaske 4 bestimmen.

Zum optimalen Ausrichten beziehungsweise zum Korrigieren der Lage der Substrate 2 bezüglich der Druckmaske 4 wird jedes Substrat 2 einzeln ausgerichtet. Dazu fährt die Einheit 13 an die entsprechende Stelle, um mittels des Sauggreifers 18 das entsprechende Substrat von der Tragplatte 20 zu entfernen. Dazu führt die Greifeinrichtung 15 das entsprechende Substrat 2 an und hebt es mittels des Sauggreifers 18 von der Tragplatte 20 ab. Die Lagekorrektur wird dann durch den Drucktisch 5 durchgeführt, indem dieser mittels der Aktoren 12 in der Ebene parallel zur Druckmaske 4 verschoben und/oder verdreht wird. Anschließend wird das Substrat 2 wieder mittels der Greifeinrichtung 15 auf der Tragplatte 20 abgesetzt und der Drucktisch 5 in seine ursprüngliche Ausgangslage zurückverlagert. Der jeweilige Verschiebeweg und/oder Verdrehwinkel des Drucktisches 5 wird dabei derart gewählt, dass nachdem der Drucktisch 5 wieder in die Ausgangsposition zurückverlagert wurde, das sich das in der verschobenen/verdrehten Position des Drucktischs 5 abgesetzte Substrat 2 nunmehr in einer optimalen beziehungsweise in der gewünschten/korrigierten Lage bezüglich der Druckmaske 4 befindet.

Alternativ zu dem oben beschriebenen Vorgehen, bei welchem die Greifeinrichtung 15 das Substrat von der Tragplatte 20 aktiv entfernt, ist gemäß einem alternativen, hier nicht dargestellten Ausführungsbeispiel vorgesehen, dass nicht die Greifeinrichtung 15 das jeweilige Substrat 2 anhebt, sondern dass der Drucktisch 5 so weit abgesenkt wird, bis das von der Greifeinrichtung gegriffene Substrat entsprechend weit von der Tragplatte 20 entfernt ist. Zum Absetzen des Substrats 2 auf der Tragplatte 20 wird dann entsprechend nicht der Sauggreifer 18 in Richtung der Tragplatte 20 bewegt, sondern der Drucktisch 5 wird in Richtung der Greifeinrichtung 15 aufwärts bewegt beziehungsweise verfahren, bis das Substrat wieder auf der Tragplatte 20 aufliegt. Natürlich ist auch eine Kombination der beiden beschriebenen Möglichkeiten denkbar, bei welcher sowohl Drucktisch 5 als auch Greifeinrichtung 15 eine Hub- beziehungsweise Absenkbewegung durchführen.

Die Ausrichteinrichtung 11 sowie die Einheit 13 bilden zusammen eine Justiereinrichtung 27, die die Ausrichtung/Position der Substrate 2 bezüglich der Druckmaske 4 für jedes Substrat 2 einzeln korrigiert. Dabei wird die eigentliche Lagekorrektur durch die Ausrichteinrichtung 11 des Drucktischs 5 durchgeführt. Dadurch lässt sich die Einheit 13 besonders kompakt und kostengünstig gestalten, was insgesamt zu Kosten- und Bauraumvorteilen bei der Druckvorrichtung 1 führt.

Der zuvor beschriebene Vorgang wird so oft wiederholt, bis alle Substrate 2 optimal bezüglich der Druckmaske 4 ausgerichtet wurden. Danach wird der Drucktisch 5 in Richtung der Druckeinrichtung 3 verlagert und ein Druckvorgang durchgeführt. Dabei werden alle auf der Tragplatte 20 befindlichen Substrate 2 gleichzeitig mit hoher Druckgenauigkeit und Wiederholbarkeit bedruckt.

Damit in dem vorliegenden Ausführungsbeispiel die Substrate 2 mittels der Greifeinrichtung 15 von der Tragplatte 20 gelöst werden können, muss die auf das jeweilige Substrat 2 ausgeübte Saugkraft der Saugvorrichtung 17 größer sein als die der Saugeinrichtung 10. Alternativ ist es auch denkbar, anstelle einer einzigen Saugeinrichtung 10 mehrere Saugeinrichtungen 10 vorzusehen, die entsprechend der Anzahl und Anordnung der zu bedruckenden Substrate vorgesehen und angeordnet werden. In dem Fall kann die jeweilige Saugeinrichtung 10, deren Substrat von der Tragplatte 20 gelöst werden soll, kurzzeitig für den Justiervorgang deaktiviert werden, um ein Abheben des entsprechenden Substrats 2 von der Tragplatte 20 zu erleichtern. Ebenso ist es denkbar, der einzigen Saugeinrichtung 10 mehrere Saugkanäle zuzuordnen, die von der Saugeinrichtung 10 zu der Unterseite der Tragplatte 20 geführt werden und schaltbar ausgebildet sind, so dass durch Umschalten beispielsweise eines jeweiligen Ventils jeder Kanal aktiviert oder deaktiviert werden kann.

Vorzugsweise ist die Druckvorrichtung 1 Teil eines Drucksystems das eine Vielzahl von Tragplatten 20 aufweist, auf denen Substrate 2 entsprechend angeordnet und in die Druckvorrichtung 1 geführt werden können. Zweckmäßigerweise sind alle der Tragplatten 20 mit entsprechenden Orientierungsmarkierungen 25 versehen, ebenso wie die Substrate 2 mit Orientierungsmarkierungen 24 versehen sein sollten beziehungsweise versehen sind. Während eine der Tragplatten 20 bedruckt oder dem Ausrichtungsprozess unterzogen wird, kann die nächste Tragplatte 20 bereits mit Substraten 2 bestückt und der Zuführeinrichtung 21 zugeführt werden.

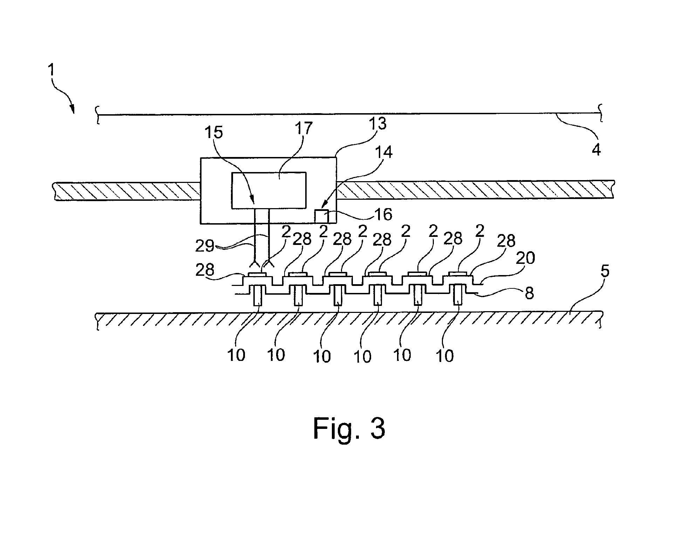

Figur 3 zeigt in einer schematischen Seitenansicht ein alternatives Ausführungsbeispiel der Druckvorrichtung 1, wobei aus den vorhergehenden Figuren bereits bekannte Elemente mit den gleichen Bezugszeichen versehen sind, so dass insofern auf die oben stehende Beschreibung verwiesen wird. Im Folgenden soll im Wesentlichen auf die Unterschiede eingegangen werden.

Im Unterschied zum vorhergehenden Ausführungsbeispiel ist die Tragplatte 20 nicht eben ausgebildet, sondern weist mehrere Erhebungen 28 bildende Wölbungen auf, wobei auf jeder Erhebung 28 ein Substrat 2 angeordnet ist. Der Drucktisch 5 weist weiterhin, wie zuvor bereits vorgeschlagen, einzelne Saugeinrichtungen 10 auf, die jeweils einem der Substrate 2 beziehungsweise einer der Erhebungen 28 zugeordnet sind. Dadurch lassen sich die Substrate 2 individuell an der Tragplatte 20 fixieren. Zusätzlich ist gemäß dem Ausführungsbeispiel von Figur 3 die Tragplattenaufnahme 8 komplementär zur Form der Tragplatte 20 ausgebildet und weist entsprechende Erhebungen auf, die von unten in die Wölbungen der Tragplatte 20 eingreifen. Dadurch wird eine Ausrichtung der Tragplatte 20 auf der Tragplattenaufnahme 8 des Drucktisches 5 vereinfacht.

Außerdem unterscheidet sich das Ausführungsbeispiel von Figur 3 von dem vorhergehenden Ausführungsbeispiel dahingehend, dass die Greifeinrichtung 15 anstelle eines Sauggreifers 18 zwei mechanische Greifer 29 aufweist, die dazu ausgebildet sind, das jeweilige Substrat insbesondere seitlich beziehungsweise von der Seite zu greifen, um es von der Tragplatte 20 zu entfernen. Hierzu können beispielsweise sogenannte Greiffinger an jeweils einem der Greifer 29 vorgesehen sein, die unter das Substrat oder in entsprechende Aussparungen des jeweiligen Substrats 2 fahrbar sind.

Selbstverständlich lassen sich die in den Ausführungsbeispielen genannten Merkmale beliebig miteinander kombinieren.

## Patentansprüche

1. Druckvorrichtung (1) zum gleichzeitigen Bedrucken mehrerer Substrate (2), mit einer insbesondere austauschbaren Tragplatte (20), auf der die Substrate (2) nebeneinander angeordnet/anordenbar sind, mit einer wenigstens eine Druckmaske (4) aufweisenden Druckeinrichtung (3), und mit einer Justiervorrichtung (27) zum Ausrichten der Substrate (2) bezüglich der wenigstens einen Druckmaske (4) vor einem Druckvorgang, wobei die Justiereinrichtung (27) eine Erfassungseinrichtung (14) zum Erfassen der Lage der Substrate (2) bezüglich der Druckmaske (4) aufweist, sowie eine Greifeinrichtung (15), die dazu ausgebildet ist, jeweils ein Substrat (2) zu greifen, von der Tragplatte (20) zu entfernen und nach erfolgter Ausrichtung wieder auf die Tragplatte (20) abzusetzen, **dadurch gekennzeichnet, dass** die Justiereinrichtung (27) eine der Tragplatte (20) zugeordnete Ausrichteinrichtung (11) aufweist, die die Tragplatte (20) in einer Ebene verschiebt und/oder verdreht, um das durch die Greifeinrichtung (15) von der Tragplatte (20) jeweils entfernte Substrat (2) auszurichten.

2. Druckvorrichtung nach Anspruch 1, **dadurch gekennzeichnet, dass** die Erfassungseinrichtung (14) vor der Ausrichtung der Substrate (2) die Lage der Tragplatte (20) erfasst wird, und dass die Ausrichteinrichtung (11) nach dem Ausrichten der Substrate (2) die Tragplatte (20) in die Lage vor der Ausrichtung der Substrate zurück verlagert.

3. Druckvorrichtung nach einem der vorhergehenden Ansprüche, **gekennzeichnet durch** eine Tragplattenaufnahme (8), der wenigstens ein ansteuerbarer Aktor (12) der Ausrichteinrichtung (11), insbesondere ein elektromotorisch, hydraulisch oder pneumatisch arbeitender Aktor, zum Verschieben und/oder Verdrehen der Tragplatte (20) zugeordnet ist, und auf welcher die Tragplatte (20) arretierbar, insbesondere automatisch arretierbar ist.

4. Druckvorrichtung nach einem der vorhergehenden Ansprüche, **dadurch gekennzeichnet, dass** die Greifeinrichtung (15) und die Erfassungseinrichtung (14) als eine Einheit (13) ausgebildet sind, die in einer Ebene, insbesondere parallel zur Druckmaske (4), verfahrbar ist.

5. Druckvorrichtung nach einem der vorhergehenden Ansprüche, **dadurch gekennzeichnet, dass** die Greifeinrichtung (15) als Saug-Greif-Einrichtung oder als mechanische Greifeinrichtung ausgebildet ist.

6. Druckvorrichtung nach einem der vorhergehenden Ansprüche, **dadurch gekennzeichnet, dass** die Tragplatte (20) mehrere Durchbrüche (26) aufweist, und dass die Tragplattenaufnahme (8) mindestens eine Saugeinrichtung (10) aufweist, die auf der den Substraten (2) gegenüberliegenden Seite der Tragplatte (20) den Durchbrüchen (26) zugeordnet angeordnet/anordenbar ist, um durch Saugwirkung die Substrate (2) auf der Tragplatte (20) zu fixieren.

7. Druckvorrichtung nach einem oder mehreren der vorhergehenden Ansprüche, **dadurch gekennzeichnet, dass** sie wenigstens eine Zuführeinrichtung (21) zum Zuführen der Tragplatte (20) zu der Tragplattenaufnahme (8) sowie eine Ausführeinrichtung (22) zum Entfernen der Tragplatte (20) von der Tragplattenaufnahme (8) aufweist.

8. Drucksystem mit einer Druckvorrichtung (1) zum gleichzeitigen Bedrucken mehrerer Substrate (2) und mit mehreren Tragplatten (20), auf denen jeweils mehrere Substrate (2) nebeneinander angeordnet/anordenbar sind, **gekennzeichnet durch** die Ausbildung der Druckvorrichtung (1) nach einem oder mehreren der vorhergehenden Ansprüche.

9. Drucksystem nach Anspruch 8, **dadurch gekennzeichnet, dass** die Tragplatten (20) und/oder die Substrate (2) mit Orientierungsmarkierungen (24,25) versehen sind, die durch die Erfassungseinrichtung (14) zum Bestimmen der Lage der Substrate (2) und/oder der jeweiligen Tragplatte (20) bezüglich der Druckmaske (4) erfasst werden.

10. Verfahren zum Betreiben einer Druckvorrichtung (1) nach einem der Ansprüche 1 bis 7 oder eines Drucksystems nach einem der Ansprüche 8 oder 9, **gekennzeichnet durch** folgende Schritte:
a) Erfassen/Bestimmen der Lage der Tragplatte (20),
b) nacheinander Erfassen der Lage jeweils eines Substrats (2) bezüglich der Druckmaske (4) mittels der Erfassungseinrichtung (14),
c) nacheinander Anheben jeweils eines Substrates (2) mittels der Greifeinrichtung (15), Verschieben und/oder Verdrehen der Tragplatte (20) zum Ausrichten des angehobenen Substrats (2) bezüglich der Druckmaske (4) derart, dass das jeweilige auf die verschobene oder verdrehte Traglatte anschließend wieder abgesetzte Substrat **durch** ein Zurückverlagern der Tragplatte in die in Schritt a) erfasste Lage bezüglich der Druckmaske (4) ausgerichtet wird, und anschließendes Absetzen des jeweiligen Substrats (2) auf die verschobene und/oder verdrehte Tragplatte (20),
d) Zurückverlagern der Tragplatte (20) in die in Schritt a) erfasste Lage, wenn alle Substrate (2) ausgerichtet wurden,
e) Durchführen eines Druckvorgangs.

## Claims

1. A printing apparatus (1) for simultaneously printing on a plurality of substrates (2), comprising a bearing plate (20) which can, in particular, be exchanged and on which the substrates (2) are/can be arranged next to each other, comprising a printing device (3) having at least one printing template (4), and comprising an adjusting device (27) for aligning the substrates (2) with respect to the at least one printing template (4) prior to a printing operation, wherein the adjusting device (27) comprises a registering device (14) for registering the position of the substrates (2) with respect to the printing template (4) as well as a gripping device (15) that is designed to grip one substrate (2) each, remove it from the supporting plate (20) and place it back again on the supporting plate (20) after completed alignment, **characterized in that** the adjusting device (27) comprises an aligning device (11) that is assigned to the supporting plate (20) and displaces and/or turns the supporting plate (20) in a plane in order to align the substrate (2) that has been removed from the supporting plate (20) by means of the gripping device (15).

2. The printing apparatus according to claim 1, **characterized in that** the registering device (14) registers the position of the supporting plate (20) prior to the alignment of the substrates (2) and that, subsequent to the alignment of the substrates (2), the aligning device (11) relocates the supporting plate (20) back to the position prior to the alignment of the substrates.

3. The printing apparatus according to any one of the preceding claims, **characterized in that** a supporting plate holder (8) which has at least one controllable actuator (12) of the aligning device (11), more particularly an electromotively, hydraulically or pneumatically operated actuator for displacing and/or turning the supporting plate (20) assigned to it and on which the supporting plate (20) can be located in position, more particularly can automatically be located in position.

4. The printing apparatus according to any one of the preceding claims, **characterized in that** the gripping device (15) and the registering device (14) are formed as a unit (13) that can be moved in a plane, more particularly in parallel to the printing template (4).

5. The printing apparatus according to any one of the preceding claims, **characterized in that** the gripping device (15) is formed as a suction gripping device or as a mechanical gripping device.

6. The printing apparatus according to any one of the preceding claims, **characterized in that** the supporting plate (20) comprises a plurality of breakthroughs (26) and that the supporting plate holder (8) comprises at least one sucking device (10) that is/can be arranged on the side of the supporting plate (20) opposite to the substrates (2) such that it is assigned to the breakthroughs (26) in order to fix the substrates (2) in position on the supporting plate (20) by sucking action.

7. The printing apparatus according to any one or a plurality of the preceding claims, **characterized in that** it comprises at least one feeding device (21) for feeding the supporting plate (20) to the supporting plate holder (8) as well as a discharging device (22) for removing the supporting plate (20) from the supporting plate holder (8).

8. A printing system comprising a printing apparatus (1) for simultaneously printing on a plurality of substrates (2) and comprising a plurality of supporting plates (20) on each of which a plurality of (20) substrates (2) are/can be arranged next to each other, **characterized by** the formation of the printing apparatus (1) according to any one or a plurality of the preceding claims.

9. The printing system according to claim 8, **characterized in that** the supporting plates (20) and/or the substrates (2) are provided with orientation marks (24, 25) which are registered by the registering device (14) for determining the position of the substrates (2) and/or the respective supporting plate (20) with respect to the printing template (4).

10. A method for operating a printing apparatus (1) according to any one of claims 1 to 7 or a printing system according to any one of claims 8 or 9, **characterized by** the following steps:
a) registering/determining the position of the supporting plate (20),
b) consecutively registering the position of one substrate (2) each with respect to the printing template (4) by means of the registering device (14),
c) consecutively lifting one substrate (2) each by means of the gripping device (15), displacing and/or turning the supporting plate (20) for aligning the lifted substrate (2) with respect to the printing template (4) in such a way that the respective substrate that has subsequently been placed back again on the displaced or turned supporting plate is aligned by relocating the supporting plate back to the position registered in step a) with respect to the printing template (4), and subsequently placing the respective substrate (2) on the displaced and/or turned supporting plate (20),
d) relocating the supporting plate (20) back to the position registered in step a) after all substrates (2) have been aligned,
e) performing a printing operation.

## Revendications

1. Dispositif d'impression (1) pour l'impression simultanée de plusieurs substrats (2), avec une plaque-support (20) en particulier interchangeable, sur laquelle les substrats (2) sont positionnés/positionnables côte à côte, avec un sous-groupe d'impression (3) comportant au moins un masque d'impression (4), et avec un dispositif d'ajustage (27) pour aligner les substrats (2) par rapport à l'au moins un masque d'impression (4) avant une opération d'impression, ledit dispositif d'ajustage (27) comportant un moyen de détection (14) pour relever la position des substrats (2) par rapport au masque d'impression (4), ainsi qu'un moyen de préhension (15), qui est conçu pour saisir respectivement un substrat (2), de l'enlever de la plaque-support (20), de l'aligner et de le reposer ensuite sur la plaque-support (20), **caractérisé en ce que** le dispositif d'ajustage (27) comporte un moyen d'alignement (11) affecté à la plaque-support (20), dont ledit moyen d'alignement (11) déplace et/ou tourne la plaque-support (20) dans un plan, pour aligner le substrat (2) respectivement enlevé de la plaque-support (20) par le moyen de préhension (15).

2. Dispositif d'impression selon la revendication 1, **caractérisé en ce que** le moyen de détection (14) relève, avant l'alignement des substrats (2), la position de la plaque-support (20), et que le moyen d'alignement (11) déplace, après l'alignement des substrats (2), la plaque-support (20) dans la position qu'elle avait avant l'alignement des substrats.

3. Dispositif d'impression selon une des revendications précédentes, **caractérisé par** une réception de plaque-support (8) à laquelle est affecté au moins un actionneur (12) pouvant être commandé et faisant partie du moyen d'alignement (11), ledit actionneur (12) fonctionnant en particulier par un système de motorisation électrique, un système hydraulique ou un système pneumatique, pour déplacer et/ou tourner la plaque-support (20), et sur lequel la plaque-support (20) peut être bloquée, en particulier par blocage automatique.

4. Dispositif d'impression selon une des revendications précédentes, **caractérisé en ce que** le moyen de préhension (15) et le moyen de détection (14) forment une unité (13), qui peut être déplacée dans un plan, en particulier parallèlement au masque d'impression (4).

5. Dispositif d'impression selon une des revendications précédentes, **caractérisé en ce que** le moyen de préhension (15) soit réalisé sous forme de dispositif d'aspiration et d'agrippement ou sous forme de dispositif de préhension mécanique.

6. Dispositif d'impression selon une des revendications précédentes, **caractérisé en ce que** la plaque-support (20) comporte plusieurs ouvertures (26) et que la réception de la plaque-support (8) comporte au moins un moyen d'aspiration (10), qui est positionné/positionnable sur le côté opposé aux substrats (2) de la plaque-support (20) et affecté aux ouvertures (26) pour fixer les substrats (2) sur la plaque-support (20) par effet d'aspiration.

7. Dispositif d'impression selon une ou plusieurs des revendications précédentes, **caractérisé en ce qu'**il comporte au moins un moyen d'alimentation (21) pour alimenter la plaque-support (20) à la réception de la plaque-support (8) ainsi qu'un moyen de retrait (22) pour enlever la plaque-support (20) de la réception de la plaque-support (8).

8. Système d'impression avec un dispositif d'impression (1) pour l'impression simultanée de plusieurs substrats (2) et avec plusieurs plaques-supports (20), sur lesquelles plusieurs substrats (2) sont respectivement positionnés/positionnables côte à côte, **caractérisé par** la configuration du dispositif d'impression (1) selon une ou plusieurs des revendications précédentes.

9. Système d'impression selon la revendication 8, **caractérisé en ce que** les plaques-supports (20) et/ou les substrats (2) comportent des repères d'orientation (24,25), qui sont relevés par le moyen de détection (14) pour déterminer la position des substrats (2) et/ou de la plaque-support respective (20) par rapport au masque d'impression (4).

10. Procédé de fonctionnement d'un dispositif d'impression (1) selon une des revendications 1 à 7 ou d'un système d'impression selon une des revendications 8 ou 9, **caractérisé par** les étapes suivantes :
a) relever/déterminer la position de la plaque-support (20),
b) relever successivement la position de respectivement un substrat (2) par rapport au masque d'impression (4) à l'aide du moyen de détection (14),
c) soulever successivement et respectivement un substrat (2) à l'aide du moyen de préhension (15), déplacer et/ou tourner la plaque-support (20) pour aligner le substrat (2) soulevé par rapport au masque d'impression (4) de sorte, que le substrat respectif, à nouveau déposé sur la plaque-support déplacée ou tournée, soit aligné par le retour de la plaque-support dans la position relevée par rapport au masque d'impression (4) dans l'étape a), et dépose consécutive du substrat (2) respectif sur la plaque-support (20) déplacée et/ou tournée,
d) déplacement retour de la plaque-support (20) dans la position relevée à l'étape a) lorsque tous les substrats (2) ont été alignés,
e) exécution d'une opération d'impression.
